# EUROPEAN PATENT APPLICATION

(11) **EP 4 415 059 A1**
(43) Date of publication of application: **14.08.2024**
(21) Application number: 23207287.6
(22) Date of filing: 01.11.2023
(51) Int. Cl.: H01L 31/068, H01L 31/0224, H01L 31/18, H01L 31/0216

(54) **BACK CONTACT SOLAR BATTERY AND PREPARATION METHOD THEREOF**

(30) Priority: 10.02.2023 CN 202310096904
(71) Applicant: Trina Solar Co., Ltd, Changzhou, Jiangsu 213031 (CN)
(72) Inventor: ZHANG, Zhuohan, Changzhou, 213031 (CN); CHEN, Daming, Changzhou, 213031 (CN); HU, Yunyun, Changzhou, 213031 (CN); LIU, Wei, Changzhou, 213031 (CN); JI, Wenxian, Changzhou, 213031 (CN); YANG, Rui, Changzhou, 213031 (CN); XU, Guanchao, Changzhou, 213031 (CN); ZHANG, Xueling, Changzhou, 213031 (CN); YANG, Guangtao, Changzhou, 213031 (CN); CHEN, Yifeng, Changzhou, 213031 (CN)
(74) Representative: Nederlandsch Octrooibureau

(57) **Abstract**

A back contact solar cell and a method for preparing a back contact solar cell are provides. The back contact solar cell includes: a silicon substrate having a front surface and a back surface opposed to each other, the silicon substrate being of a first doping type; a first emitter and a second emitter arranged on the back surface of the silicon substrate; a first isolation region and a second isolation region, the first isolation region surrounding the second isolation region and the second isolation region surrounding the second emitter; and a second electrode, a first part of the second electrode being in contact with the second emitter, a second part of the second electrode being provided on a side of the corresponding first emitter away from the silicon substrate, and the first isolation region surrounding the first part of the second electrode; or the entire second electrode being in contact with the second emitter, and the first isolation region surrounding the entire second electrode, wherein the first emitter is of a second doping type, the second emitter is of the first doping type.

## Description

### Technical Field

The present application mainly relates to photovoltaics, and specifically to a back contact solar cell and preparation method thereof.

### Background

The photoelectric conversion efficiency of back contact solar cell has exceeded 26%, which has great application prospects. The electrodes in a back contact solar cell are located on the back of the solar cell, which increases the area of the solar cell available to receive sunlight. There is a reverse leakage problem in the back contact solar cell, and reducing the reverse leakage can improve the efficiency of the back contact solar cell.

### Brief Summary

In order to solve above defects, the purpose of the present application is to propose a back contact solar cell and a method for preparing the back contact solar cell, both of which can avoid or reduce the reverse leakage in the back contact solar cell.

In order to achieve above purpose, the present application proposes a back contact solar cell, comprising a silicon substrate having a front surface and a back surface, the silicon substrate being of a first doping type; a first emitter and a second emitter arranged on the back surface of the silicon substrate, the first emitter being of a second doping type, the second emitter being of the first doping type; a second isolation region surrounding the first isolation region, a second isolation region surrounding the second emitter; a second electrode having a first part and a second part, the first part being in contact with the second emitter, the second part being provided on a side of the corresponding first emitter away from the silicon substrate, and the first isolation region surrounding the first part of the second electrode; or the entire second electrode being in contact with the second emitter, and the first isolation region surrounding the entire second electrode.

In an embodiment, the solar cell further comprises an insulating layer provided between the second part of the second electrode and the corresponding first emitter.

In an embodiment, the entire second electrode are in contact with the second emitter, wherein the first isolation region surrounds the entire second electrodes.

In an embodiment, the first emitter includes a diffusion layer, a tunnel oxide layer, and a polysilicon layer sequentially arranged on the back surface of the silicon substrate, wherein the diffusion layer is of the second doping type, and the polysilicon layer is of the second doping type.

In an embodiment, further comprising a first passivation layer and an anti-reflection layer sequentially arranged on the front surface of the silicon substrate.

In an embodiment, the first passivation layer comprises a chemical passivation layer arranged on the front surface of the silicon substrate and a field passivation layer arranged on a side of the chemical passivation layer away from the silicon substrate.

In an embodiment, the solar cell further comprises a second passivation layer arranged on the back surface of the silicon substrate.

In order to achieve above purpose, the present application also proposes a method for preparing a back contact solar cell, comprising the following steps: providing a silicon substrate having a front surface and a back surface opposed to each other, the silicon substrate being of a first doping type; forming a first emitter and a second emitter on the back surface of the silicon substrate; forming a first isolation region and a second isolation region on the back surface of the silicon substrate, the first isolation region surrounding the second isolation region and the second isolation region surrounding the second emitter; and forming a second electrode, a first part of the second electrode being in contact with the second emitter, a second part of the second electrode being provided on a side of the corresponding first emitter away from the silicon substrate, and the first isolation region surrounding the first part of the second electrode; or the entire second electrode being in contact with the second emitter, and the first isolation region surrounding the entire second electrode, wherein, the first emitter is of a second doping type, the second emitter is of the first doping type.

In an embodiment, the first emitter includes a diffusion layer, a tunnel oxide layer, and a polysilicon layer, and the diffusion layer, the tunnel oxide layer sequentially arranged on the back surface of the silicon substrate, wherein both of the diffusion layer and the polysilicon layer are of the second doping type.

In an embodiment, the solar cell further comprises sequentially forming a first passivation layer and an anti-reflection layer on the front surface of the silicon substrate.

In an embodiment, the first passivation layer comprises a chemical passivation layer arranged on the front surface of the silicon substrate and a field passivation layer arranged on a side of the chemical passivation layer away from the silicon substrate.

### Brief Description of the Drawings

In order to make the features and advantages of the present application more obvious and understandable, the specific implementation methods of the present application will be described in detail below in conjunction with the drawings, wherein:
Fig. 1 is a schematic bottom view of a back contact solar cell according to an embodiment of the present application;
Fig. 2 is a schematic cross-sectional view along line A-A in Fig. 1;
Fig. 3 is a schematic cross-sectional view along line B-B in Fig. 1;
Fig. 4 is a schematic bottom view of a back contact solar cell according to another embodiment of the present application;
Fig. 5 is an exemplary flow chart of a method for preparing a back contact solar cell according to an embodiment of the present application.

### Detailed Description

In order to make the above-mentioned features and advantages of the present application more comprehensible, the specific implementation methods of the present application will be described in detail below in conjunction with the drawings.

Many specific details are set forth in the following description to facilitate a full understanding of the present application, but the present application can also be implemented in other ways than those described here, so the present application is not limited by the specific embodiments disclosed below.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

The flow chart is used in this application to illustrate the operations performed by the system according to the embodiment of this application. It should be understood that the preceding or following operations are not necessarily performed in an exact order. Instead, various steps may be processed in reverse order or concurrently. At the same time, other operations can either add to these procedures, or a certain step or steps can be removed from these procedures.

The back contact solar cell of the present application will be described through specific examples.

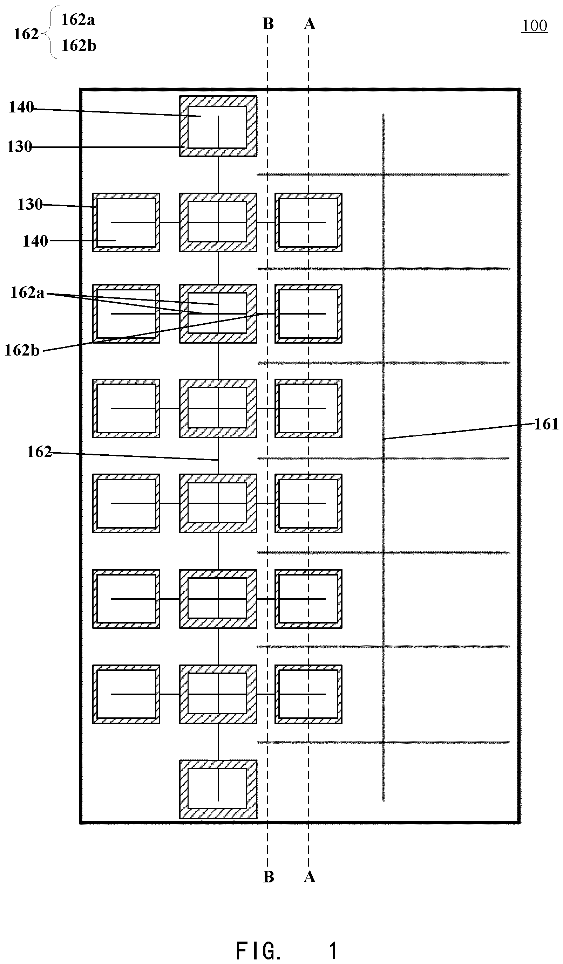

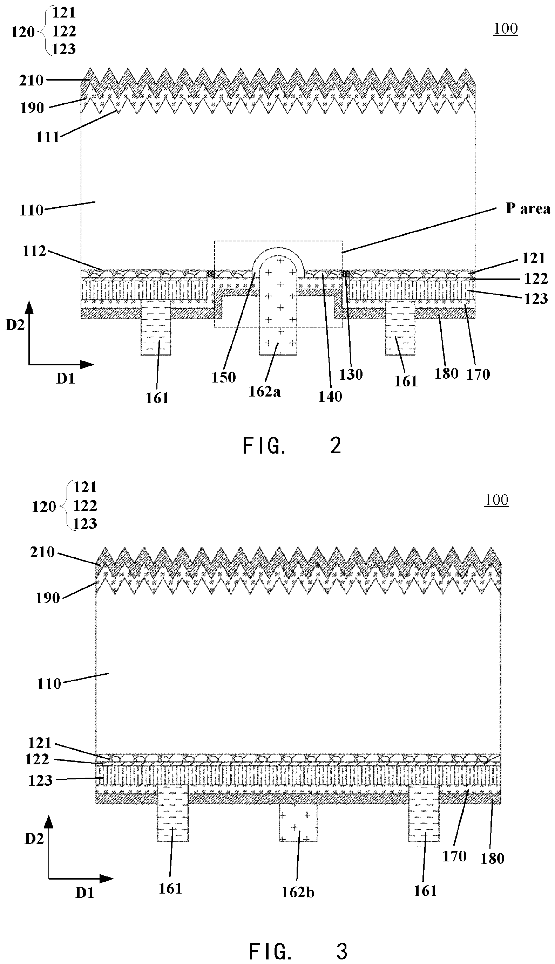

Fig. 1 is a schematic bottom view of a back contact solar cell according to an embodiment of the present application, and Fig. 2 is a schematic cross-sectional view along line A-A in Fig. 1. Referring to Fig. 1 and Fig. 2, the back contact solar cell 100 comprises a silicon substrate 110, a first emitter 120, a first isolation region 130, a second isolation region 140 and a second emitter 150. It should be noted that, limited by the scope of the drawing, Fig. 2 only shows part of the schematic cross-sectional view along line A-A. It can be seen from Fig. 2 that since the side of the first isolation region 130 and the second isolation region 140 along the thickness direction D2 away from the silicon substrate 110 is covered with other material layers, the first isolation region 130 and the second isolation region 140 cannot actually be seen in the schematic bottom view of Fig. 1. For convenience of description, the positions of the first isolation region 130 and the second isolation region 140 are schematically shown in Fig. 1.

Specifically, referring to Fig. 2, the silicon substrate 110 has a front surface 111 and a back surface 112 opposed to each other along the thickness direction D2, and the silicon substrate 110 is of a first doping type. The first doping type may be P-type, that is, the silicon substrate 110 is a P-type silicon substrate; or the first doping type may be N-type, that is, the silicon substrate 110 is an N-type silicon substrate. The specific doping elements for forming the P-type silicon substrate and the N-type silicon substrate are not limited.

In the view of Fig. 2, the first emitter 120, the first isolation region 130, the second isolation region 140 and the second emitter 150 are arranged on the back surface 112 of the silicon substrate 110 along the first direction D1, wherein the first emitter is of a second doping type, and the second emitter 150 is of the first doping type. In Fig. 2, the right side of the first isolation region 130 is in contact with the first emitter 120, the left side of the first isolation region 130 is in contact with the right side of the second isolation region 140, and the left side of the second isolation region 140 is in contact with the second emitter 150. It can be understood that the above description of the positional relationship between the first emitter 120, the first isolation region 130, the second isolation region 140, and the second emitter 150 is for the second emitter 150 and the first emitter 120, the first isolation region 130,the second isolation region 140 located on the right side thereof. For the positional relationship between the second emitter 150 and the first emitter 120, the first isolation region 130, and the second isolation region 140 on the left side thereof, reference may be made to the above description, and will not be elaborated here.

It should be noted that the positional relationship among the first emitter 120, the first isolation region 130, the second isolation region 140 and the second emitter 150 is not limited to the embodiment in Fig. 1. For example, in some other embodiments, the first isolation region 130 and the second isolation region 140 are arranged between the first emitter 120 and the second emitter 150 along the first direction D1, and are not in contact with each other; or the first isolation region 130 and the second isolation region 140 are in contact with each other, and the first isolation region 130 is not in contact with the first emitter 120, and the second isolation region 140 is not in contact with the second emitter 150.

Referring to Fig. 1 and Fig. 2, in an embodiment, the back contact solar cell 100 further comprising a first electrode 161 and a second electrode 162. The first electrode 161 is electrically connected to the first emitter 120 realized by being in contact with the first emitter 120. Similarly, the second electrode 162 is electrically connected to the second emitter 150 by being in contact with the second emitter 150. Here, the way that the second electrode 162 is electrically connected with the second emitter 150 includes two situations: the first situation is that a part of the second electrode 162 is in contact with the second emitter 150; the second situation is that entire second electrode 162 are in contact with the second emitter 150. The above two situations will be described as followed.

Situation 1: A part of the second electrode is in contact with the second emitter.

Referring to Fig. 1, Fig. 1 shows the topography of the back surface of the back contact battery 100. Different from the topography shown by the first electrode 161 and the second electrode 162 in Fig. 2, in the view of Fig. 1, the first electrode 161 and the second electrode 162 are shown as line segments. Understandably, this is due to the viewing angle.

In Fig. 1, the first isolation region 130 surrounds the second isolation region 140. As shown in Fig. 2, the second isolation region 140 surrounds the second emitter 150, and the first part 162a of the second electrode 162 is surrounded by the first isolation region 130. Referring to Fig. 3, which is a schematic cross-sectional view along line B-B in Fig. 1, the second part 162b of the second electrode 162 is provided on the side of the corresponding first emitter 120 away from the silicon substrate 110. In other words, in Fig. 1, the first isolation region 130 is represented as a rectangular frame, the part of the second electrode located inside the rectangular frame is the first part 162a of the second electrode, and the part of the second electrode located outside the rectangular frame is the second electrode part 162b.

Referring Fig.1 and Fig. 2 concurrently, since the side of the first emitter 120 and the second emitter 150 away from the silicon substrate 110 is covered with other material layers, the first emitter 120 and the second emitter 150 cannot be seen in Fig 1. However, for a clearer understanding of the planar distribution of the second electrodes in situation 1, the first emitter and the second emitter are firstly described here in view of Fig. 1. In Fig. 1, the second emitter 150 is located under the first part 162a of the second electrode; moreover, the first emitter 120 (as shown in FIG. 3 ) is located under the second part 162b of the second electrode, and an insulating layer (not shown) is located between the second part 162b of the second electrode and the first emitter under it, so the second electrode will not be electrically connected to the first emitter. The above-mentioned " under " refers to a direction toward the inside of the paper.

Referring to Fig. 2 and Fig. 3, the back contact solar cell 100 further comprises a second passivation layer 170 and a third passivation layer 180 that sequentially provided on the back surface of the silicon substrate 110 along the thickness direction D2. The second part 162b of the second electrode is provided on a side of the third passivation layer 180 away from the third passivation layer 180 along the thickness direction D2. In some embodiments, the back contact solar cell 100 further includes an insulating layer (not shown). As shown in Fig. 3, the insulating layer is provided between the second part 162b of the second electrode and the third passivation layer 180. Alternatively, use methods such as etching to remove the second passivation layer 170 and the third passivation layer 180 at the position of the second part 162b of the second electrode in Fig 3, further exposing the first emitter 120, and correspondingly, the insulating layer is provided between the second part 162b of the second electrode and the corresponding first emitter 120. In some embodiments, when the back contact solar cell 100 does not comprise the second passivation layer 170 and the third passivation layer 180, an insulating layer is provided between the second part 162b of the second electrode and the corresponding first emitter 120. Referring back to Fig. 1, the first isolation region 130 surrounds the first part 162a of the second electrode, and an insulating layer is provided between the second part 162b of the second electrode and the corresponding first emitter 120, therefore, the second electrode 162 will not be electrically connected to the first emitter 120.

In one embodiment, the second passivation layer and the third passivation layer are respectively one or more combinations of silicon nitride, aluminum oxide, titanium oxide, silicon oxide, and silicon oxynitride.

Further, as shown in Fig. 1 and Fig. 2, the second emitter 150 is surrounded by the second isolation region 140, and the second isolation region 140 is surrounded by the first isolation region 130. In this way, the first emitter 120 and the second emitter 150 are isolated by the first isolation region 130 and the second isolation region 140, so as to avoid battery leakage due to the contact between the first emitter 120 and the second emitter 150.

Situation 2: All the second electrode is in contact with the second emitter.

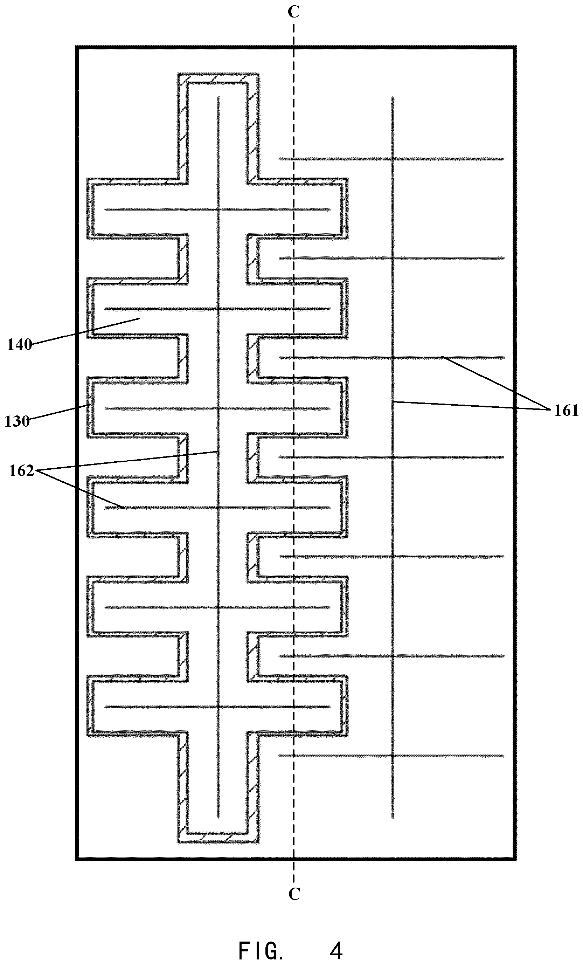

Referring to FIG. 4, which is a schematic bottom view of a back contact solar cell according to another embodiment of the present application, in connection with Fig. 2. The schematic cross-sectional view shown in Fig. 2 can also represent the schematic cross-sectional view long line C-C in Fig. 4. Different from Fig. 1, in Fig. 4, all the second electrode 162 is in contact with the second emitter 150, and the second isolation region 140 surrounds all the second electrode 162, and the first isolation region 130 surrounds the second isolation region 130. It can be seen that in Fig. 4, the first isolation region 130 surrounds all the second electrode 162.

Further, similar to situation 1, the first emitter 120 and the second emitter 150 are isolated by the first isolation region 130 and the second isolation region 140, so as to avoid battery leakage due to the contact between the first emitter 120 and the second emitter 150.

In the above embodiments, the second emitter has been illustrated, and the first emitter will be described next.

Referring to Fig. 2, the first emitter 120 comprises a diffusion layer 121, a tunnel oxide layer 122 and a polysilicon layer 123. The diffusion layer 121, the tunnel oxide layer 122 and the polysilicon layer 123 are sequentially provided on the back surface of the silicon substrate 110 along the thickness direction D2, wherein both the diffusion layer 121 and the polysilicon layer 123 are of the second doping type. In some embodiments, the thickness of the tunnel oxide layer 122 is 1-20 nm, and the thickness of the polysilicon layer 123 is 20-1000 nm. The tunnel oxide layer 122 may be implemented as silicon dioxide. The tunnel oxide layer 122 and the polysilicon layer 123 can realize the selective collection of carriers, that is, the majority carriers can easily pass through the tunnel oxide layer 122, while the minority carriers can hardly pass through the tunnel oxide layer 122.

In order to illustrate the technical effect of isolating the first emitter and the second emitter by the first isolation region and the second isolation region in the foregoing embodiments more clearly, the first isolation region and the second isolation region will be further described.

Referring to FIG. 2, the first isolation region 130 is provided between the first emitter 120 and the second isolation region 140 along the first direction D 1. The first isolation region 130 may be implemented as a silicon substrate between the first emitter 120 and the second isolation region 140, or as other materials between the first emitter 120 and the second isolation region 140, for example, the second passivation layer. In other words, the first isolation region 130 located between the first emitter 120 and the second isolation region 140 along the first direction D1 has the technical effect of isolating the first emitter 120 and the second emitter 150. In some embodiments, the first isolation region 130 is of the first doping type. As shown in Fig. 2, the side of the first isolation region 130 close to the silicon substrate 110 along the thickness direction D2 may also have a pyramid textured topography.

In Fig. 2, all the second isolation region 140 is of the second doping type. In this case, the second isolation region 140 may be the diffusion layer 121 remaining in the P area. In some other embodiments, the doping type of the second isolation region 140 may also be as follows: a part of the second isolation region is of the first doping type, and the other part of the second isolation region is of the second doping type, wherein the term "part" and "the other part" may or may not form all of the second isolation region; or all of the second isolation region are of the first doping type.

For a clearer understanding of the first isolation region and the second isolation region in the back contact solar cell in the above embodiment, an example for explaining the formation process of the first isolation region and the second isolation region is given here.

Referring to Fig. 2, the tunnel oxide layer 122 and the polysilicon layer 123 cover part of the back surface of the silicon substrate 110. The process of forming the tunnel oxide layer 122 and the polysilicon layer 123 partially covering the back surface of the silicon substrate 110 is as follows. First, the tunnel oxide layer 122 is formed on the back surface of the silicon substrate 110, which covers the entire back surface, and then the polysilicon layer 123 is formed on the surface of the tunnel oxide layer 122, which covers the tunnel oxide layer 122. Then, the unnecessary tunnel oxide layer 122 and the polysilicon layer 123 are removed by etching and other methods, and the tunnel oxide layer 122 and the polysilicon layer 123 of the first emitter 120 are reserved. When the polysilicon layer located in the P area is reserved, all the second isolation region 140 is of the second doping type; when a part of the polysilicon layer located in the P area is reserved, a part of the second isolation region 140 are of the first doping type, and the other part are of the second doping type; when all the polysilicon layer in the P area is removed, all the second isolation region 140 is of the first doping type. It should be noted that the above embodiment is only one situation of forming the first isolation region and the second isolation region, and the method of forming the first isolation region and the second isolation region is not limited to the above examples.

Referring to Fig. 2, the side of the first isolation region 130 close to the silicon substrate 110 has a pyramid textured topography. The pyramid textured topography of the first isolation region 130 and the pyramid textured topography at the front surface of the silicon substrate 110 are formed in the same texturing process, the isolation process of forming the first isolation region 130 and the second isolation region 140 can be combined with the texturing process to simplify the process. In some other embodiments, the surface of the second isolation region 140 away from the silicon substrate 110 along the thickness direction D2 is flat. The flat topography can be obtained by chemical mechanical polishing (CMP).

In one embodiment, as shown in Fig. 2, a first passivation layer 190 and an anti-reflection layer 210 are sequentially formed on the front surface 111 of the silicon substrate 110 along the thickness direction D2. Methods of forming the first passivation layer 190 and the anti-reflection layer 210 include chemical vapor deposition (CVD) and/or physical vapor deposition (PVD). In some embodiments, the first passivation layer 190 includes a chemical passivation layer and a field passivation layer. When forming the first passivation layer 190, the chemical passivation layer is first formed on the front surface 111 of the silicon substrate 110, and then the field passivation layer is formed on the side of the chemical passivation layer away from the silicon substrate 110. In some embodiments, the front surface 111 of the silicon substrate 110, the first passivation layer 190 and the anti-reflection layer 210 located on the front surface 111 have a pyramid texture topography. When the solar cell is working, sunlight is incident on the silicon substrate 110 from the front surface of the silicon substrate 110, and the pyramid texture topography can play a role in trapping light and reducing surface reflection, thereby improving the light utilization rate of the solar cell.

In the above embodiments, the first emitter and the second emitter are isolated by the first isolation region and the second isolation region, so as to avoid excessive leakage of the solar cell due to the contact between the first emitter and the second emitter.

The following embodiments of the present application also provide a method for preparing a back contact solar cell, and the preparation method will be described with the following embodiments.

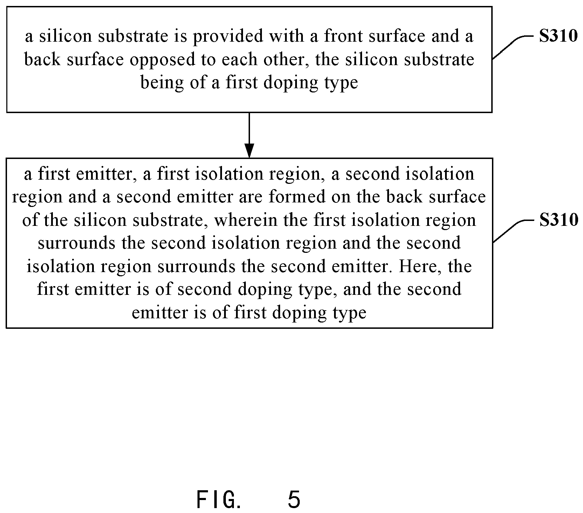

Fig. 5 is a flowchart of a preparation method for a back contact solar cell according to an embodiment of the present application. As shown in Fig. 5, the preparation method of this embodiment comprises the following steps.

At step S310, a silicon substrate is provided with a front surface and a back surface opposed to each other, the silicon substrate being of a first doping type.

At step S320, a first emitter, a first isolation region, a second isolation region and a second emitter are formed on the back surface of the silicon substrate, wherein the first isolation region surrounds the second isolation region and the second isolation region surrounds the second emitter. Here, the first emitter is of second doping type, and the second emitter is of first doping type.

The above steps S310 and S320 will be specifically described below.

Referring to Fig. 2, in step S310, a silicon substrate 110 is provided, and the silicon substrate 110 has opposite front surface 111 and back surface 112 along the thickness direction D2. Here, the silicon substrate 110 is of a first doping type.

In step S320, the first emitter 120, the first isolation region 130, the second isolation region 140 and the second emitter 150 are formed on the back surface 112 of the silicon substrate 110, the first emitter 120 is of the second doping type, the second emitter 150 is of the first doping type. As shown in Fig. 1, the first isolation region 130 surrounds the second isolation region 140, and the second isolation region 140 surrounds the second emitter 120, so that the first emitter 120 and the second emitter 150 are isolated by the first isolation region 130 and the second isolation region 140, thereby preventing the first emitter 120 from contacting the second emitter 150.

Referring to Fig. 1 and Fig. 2 concurrently, in an embodiment, forming the first electrode 161 which is in contact with the first emitter 120, and forming the second electrode 162 which is in contact with the second emitter 150. In this way, the electrical connection between the first electrode 161 and the first emitter 120, the electrical connection between the second electrode 162 and the second emitter 150 are both realized.

In one embodiment, the first part 162a of the second electrode is in contact with the second emitter 150, the second part 162b of the second electrode is provided on the side of the corresponding first emitter away from the silicon substrate 110, and an insulating layer (not shown) is provided between the second part 162b of the second electrode and the corresponding first emitter, as shown in Fig. 1, wherein the first isolation region 130 surrounds the first part 162a of the second electrode.

In another embodiment, referring to Fig. 4, difference from Fig. 2, all the second electrode 162 is in contact with the second emitter 150, and the first isolation region 130 surrounds all the second electrode 162.

Referring to Fig. 2, in one embodiment, the first emitter 120 comprises a diffusion layer 121, a tunnel oxide layer 122 and a polysilicon layer 123. As shown in Fig. 2, the diffusion layer 121 is provided on the back surface of the silicon substrate 110, the tunnel oxide layer 122 is provided on the side of the diffusion layer 121 away from the silicon substrate 110 along the thickness direction D2, and the polysilicon layer 123 is provided on the side of the tunnel oxide layer 122 away from the silicon substrate 110 along the thickness direction D2. The tunnel oxide layer 122 and the polysilicon layer 123 can realize the selective collection of carriers, that is, the majority carriers can easily pass through the tunnel oxide layer 122, while the minority carriers can hardly pass through the tunnel oxide layer 123. Here, both the diffusion layer 121 and the polysilicon layer 123 are of the second doping type.

In one embodiment, as shown in FIG. 2, the first passivation layer 190 and the anti-reflection layer 210 are sequentially formed on the front surface of the silicon substrate 110 along the thickness direction D2. Methods of forming the first passivation layer 190 and the anti-reflection layer 210 include chemical vapor deposition (CVD) and/or physical vapor deposition (PVD). In some embodiments, the first passivation layer 190 includes a chemical passivation layer and a field passivation layer. When forming the first passivation layer 190, the chemical passivation layer is first formed on the front surface of the silicon substrate 110, and then the field passivation layer is formed on the side of the chemical passivation layer away from the silicon substrate 110.

Continuing referring to Fig. 2, in one embodiment, the first isolation region 130 has a pyramid texture topography. The method for forming the pyramid texture topography includes etching the side of the first isolation region 130 away from the silicon substrate 110 by using an alkaline solution. In one embodiment, the pyramid textured topography of the first isolation region 130 and the pyramid textured topography on the front surface of the silicon substrate 110 are formed in the same texturing process, thereby simplifying the process. In some other embodiments, the surface of the second isolation region 140 away from the silicon substrate 110 along the thickness direction D2 is flat. The flat topography can be obtained by chemical mechanical polishing (CMP).

In the above embodiments, the first emitter and the second emitter are isolated by the first isolation region and the second isolation region, so as to avoid excessive leakage of the solar cell due to the contact between the first emitter and the second emitter.

The basic concepts have been described above, obviously, for those skilled in the art, the above disclosure of the invention is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

## Claims

1. A back contact solar cell, **characterized in that**, comprising:
a silicon substrate having a front surface and a back surface opposed to each other, the silicon substrate being of a first doping type;
a first emitter and a second emitter arranged on the back surface of the silicon substrate;
a first isolation region and a second isolation region, the first isolation region surrounding the second isolation region and the second isolation region surrounding the second emitter; and
a second electrode, a first part of the second electrode being in contact with the second emitter, a second part of the second electrode being provided on a side of the corresponding first emitter away from the silicon substrate, and the first isolation region surrounding the first part of the second electrode; or the entire second electrode being in contact with the second emitter, and the first isolation region surrounding the entire second electrode,
wherein the first emitter is of a second doping type, the second emitter is of the first doping type.

2. The solar cell of claim 1, **characterized in that**, further comprising an insulating layer provided between the second part of the second electrode and the corresponding first emitter.

3. The solar cell of claim 1, **characterized in that**, the entire second electrode are in contact with the second emitter, wherein the first isolation region surrounds the entire second electrodes.

4. The solar cell of claim 1, **characterized in that**, the first emitter includes a diffusion layer, a tunnel oxide layer, and a polysilicon layer sequentially arranged on the back surface of the silicon substrate, wherein the diffusion layer is of the second doping type, and the polysilicon layer is of the second doping type.

5. The solar cell of claim 1, **characterized in that**, further comprising a first passivation layer and an anti-reflection layer sequentially arranged on the front surface of the silicon substrate.

6. The solar cell of claim 5, **characterized in that**, the first passivation layer comprises a chemical passivation layer arranged on the front surface of the silicon substrate and a field passivation layer arranged on a side of the chemical passivation layer away from the silicon substrate.

7. The solar cell of claim 1, **characterized in that**, further comprising, a second passivation layer arranged on the back surface of the silicon substrate.

8. A method for preparing a back contact solar cell, **characterized in that**, comprising the following steps:
providing a silicon substrate having a front surface and a back surface opposed to each other, the silicon substrate being of a first doping type;
forming a first emitter and a second emitter on the back surface of the silicon substrate;
forming a first isolation region and a second isolation region on the back surface of the silicon substrate, the first isolation region surrounding the second isolation region and the second isolation region surrounding the second emitter; and
forming a second electrode, a first part of the second electrode being in contact with the second emitter, a second part of the second electrode being provided on a side of the corresponding first emitter away from the silicon substrate, and the first isolation region surrounding the first part of the second electrode; or the entire second electrode being in contact with the second emitter, and the first isolation region surrounding the entire second electrode,
wherein, the first emitter is of a second doping type, the second emitter is of the first doping type.

9. The method of claim 8, **characterized in that**, the first emitter includes a diffusion layer, a tunnel oxide layer, and a polysilicon layer, and the diffusion layer, the tunnel oxide layer sequentially arranged on the back surface of the silicon substrate, wherein both of the diffusion layer and the polysilicon layer are of the second doping type.

10. The method of claim 8, **characterized in that**, further comprising sequentially forming a first passivation layer and an anti-reflection layer on the front surface of the silicon substrate.

11. The method of claim 10, **characterized in that**, the first passivation layer comprises a chemical passivation layer arranged on the front surface of the silicon substrate and a field passivation layer arranged on a side of the chemical passivation layer away from the silicon substrate.
